# EUROPÄISCHE PATENTSCHRIFT

(11) **EP 0 975 705 B1**
(45) Veröffentlichungstag und Bekanntmachung des Hinweises auf die Patenterteilung: **13.03.2002**
(21) Anmeldenummer: 98919271.1
(22) Anmeldetag: 15.04.1998
(51) Int. Cl.: C09G 1/02, H01L 21/321

(54) **PUFFERLÖSUNGEN FÜR SUSPENSIONEN, VERWENDBAR ZUM CHEMISCH-MECHANISCHEN POLIEREN**
BUFFER SOLUTIONS FOR SUSPENSIONS USED IN CHEMICAL-MECHANICAL POLISHING
SOLUTIONS TAMPONS POUR SUSPENSIONS S'UTILISANT POUR LE POLISSAGE CHIMICO-MECANIQUE

(30) Priorität: 17.04.1997 DE 19715975
(43) Veröffentlichungstag der Anmeldung: 02.02.2000
(73) Patentinhaber: MERCK PATENT GmbH, 64293 Darmstadt (DE)
(72) Erfinder: DUSEMUND, Claus, D-66583 Spiesen-Elversberg (DE); RHEIN, Rudolf, D-64646 Heppenheim (DE); SCHWEIKERT, Manuela, D-64342 Seeheim-Ober Beerbach (DE); HOSTALEK, Martin, D-64291 Darmstadt (DE)
(86) Internationale Anmeldenummer: EP9802209
(87) Internationale Veröffentlichungsnummer: WO9847976

(56) Entgegenhaltungen:
- EP-A- 0 773 270
- GB-A- 2 318 998
- US-A- 5 139 571
- PATENT ABSTRACTS OF JAPAN vol. 097, no. 007, 31. Juli 1997 & JP 09 063996 A (NIPPON STEEL CORP), 7. März 1997

## Beschreibung

Die vorliegende Erfindung betrifft Puffersysteme in Form von Lösungen oder von Salzen zur Herstellung von Suspensionen, welche zum chemisch-mechanischen Polieren einsetzbar sind. Insbesondere sind diese Puffersysteme einsetzbar zur Herstellung von Suspensionen mit einem hohen pH-Wert von 9,5- 13, die zum chemisch-mechanischen Polieren von Si- und Metalloberflächen von Halbleitern, den sogenannten Wafem, verwendet werden.

Typische Halbleiterschaltungen sind üblicherweise so aufgebaut, daß als Substrat Silizium oder Galliumarsenid verwendet wird, worauf eine Vielzahl von integrierten Schaltungen aufgebracht ist. Die verschiedenen Schichten, aus denen diese integrierten Schaltungen aufgebaut sind, sind entweder leitend, isolierend oder besitzen Halbleitereigenschaften. Um solch eine Halbleiterstruktur aufzubauen, ist es unerläßlich, daß der verwendete Wafer eine absolut ebene Oberfläche aufweist. Daher ist es häufig notwendig, die Oberfläche oder einen Teil der Oberfläche eines Wafers zu polieren.

Weiterentwicklungen in der Halbleitertechnologie haben zu immer größeren Integrationstiefen und einer fortschreitenden Miniaturisierung, verbunden mit immer enger werdenden Schaltungen, geführt, wodurch immer höhere Anforderungen an die Fertigungsmethoden gestellt werden. Beispielsweise ist es notwendig bei solchen Halbleiterelementen, dünne leitende Linien oder ähnliche Strukturen auf vorab gebildeten Strukturen zu bilden. Probleme bereitet dabei, daß die Oberfläche der vorher gebildeten Strukturen häufig unregelmäßig ist. Um in der folgenden photolithographischen Behandlung ein zufriedenstellendes Ergebnis erzielen zu können, ist daher eine Planarisierung der Oberfläche notwendig.
Daher sind die Methoden und Mittel, mit denen die wiederholt notwendige Planarisierung durchgeführt wird, ein zentrales Thema in der Halbleiterherstellung. In der Fachsprache wird dieser Vorgang unter dem Begriff des chemisch-mechanischen Polierens verstanden. Demgemäß sind daher bei diesem Verfahrensschritt sowohl die eingesetzten technischen Vorrichtungen als auch die verwendeten chemischen Komponenten, woraus die Formulierungen der eingesetzten Poliersuspensionen zusammengesetzt sind, aber auch die Versorgungssysteme, mit deren Hilfe letztere während des Polierens zur Verfügung gestellt werden, von großem Interesse.

Im allgemeinen erfolgt das chemisch-mechanische Polieren (CMP), indem der Wafer unter gleichmäßigem Druck gegen ein Poliertuch gedreht wird, welches gleichmäßig mit einer Poliersuspension getränkt ist. Ausführlicher sind solche Verfahren zum chemisch-mechanischen Polieren in den US-Patenten US-A-4 671 851, US-A-4 910 155 und US-A-4 944 836 beschrieben.

Zur Erzielung gleichbleibender Ergebnisse sind kontinuierlich gleichbleibende chemische Eigenschaften der zum Polieren eingesetzten Suspensionen, den sogenannten Slurries, von großer Bedeutung. Üblicherweise handelt es sich hierbei um verdünnte Suspensionen, welche aus den Vorratsbehältem über möglichst kurze Leitungen, gegebenenfalls unter Vermischung an den Wirkort gebracht werden. Anforderungen an gleichbleibende Eigenschaften dieser Slurries betreffen insbesondere den Gehalt an Feststoffen, welche normalerweise aus Silikat- oder Aluminiumoxidpartikeln bestehen, die Größenverteilung der Feststoffpartikel, den pH-Wert aber auch sonstige darin enthaltene lonen, wobei Feststoffpartikel und pH-Wert das Polierergebnis in besonderer Weise zu beeinflusssen scheinen, auch wenn der Gehalt an Ionen, z. B. freigesetzt aus den Lagerbehältern, Versorgungssystemen oder durch Zersetzungsvorgänge innerhalb der Slurries selbst, ebenfalls nicht zu vernachlässigen sein dürfte. Weiterhin können unerwünschte Agglomerat-, Aggregat- oder Gelbildungen in den Slurries auftreten und deren Handhabung ebenso nachteilig beeinflussen wie das Polierergebnis.

Bei den Poliersuspensionen kann es sich sowohl um basische als auch um saure handeln. Basische Slurries weisen unterschiedliche Probleme in der Anwendung auf, je nach dem welche Base zur Einstellung des pH-Werts verwendet wurde. Die Slurries, deren pH-Wert durch KOH eingestellt wurde, scheinen als solche stabiler zu sein, weisen aber höhere Kontaminationsgrade an lonen und Fremdpartikeln auf, so daß bei Verwendung solcher Systeme den Reinigungsschritten im Anschluß an das Polieren erheblich größere Bedeutung zukommt. Beispielsweise wird in dem Patent US-A-5 245 790 die Verwendung solcher Suspensionen unter Einwirkung von Ultraschall beschrieben. Durch US-A- 5 244 534 wird ein Verfahren zur Herstellung eines leitenden Kontakts in einer isolierenden Schicht offenbart. Die darin beschriebenen Slurries, welche als Feststoffpartikel beispielsweise Al₂O₃, als Ätzmittel Wasserstoffperoxid, sowie entweder KOH oder NH₄OH zur Einstellung des pH-Werts enthalten, werden im ersten Polierschritt verwendet, um Wolfram in einer vorherbestimmbaren Menge zu entfernen und gleichzeitig nur sehr wenig von der Isolierschicht abzutragen. Im darauffolgenden chemisch-mechanischen Polierschritt wird eine Suspension verwendet, welche aus einem Feststoff, wie Al₂O₃, einem Oxidationsmittel, wie Wasserstoffperoxid, und Wasser besteht. Ähnliche Zusammensetzungen weisen auch die in US-A-5 209 816 offenbarten CMP-Suspensionen auf, in denen Phosphorsäure, Wasserstoffperoxid, Wasser und Feststoffpartikel enthalten sind, während aus den Patenten US-A-5 157 876 und
US-A-5 137 544 Zusammensetzungen bekannt sind, die Wasser, kolloides Silikat und Natriumhypochlorid enthalten. In US-A-4 956 313 werden Slurries beschrieben, welche Aluminiumoxidpartikel, entionisiertes Wasser und ein Oxidationsmittel enthalten.

Im Gegensatz zu Formulierungen, deren pH-Wert mit KOH oder NaOH, wie in US 5,139,571 erwähnt, eingestellt worden ist, ist bei CMP-Suspensionen, denen zu diesem Zweck Ammoniaklösung zugesetzt worden ist, das Problem der Verunreinigung durch Fremdionen zwar geringer, jedoch neigen diese eher zur Gelbildung und zu Veränderungen des pH-Werts. Außerdem spielt hier der Geruch eine besondere Rolle. Dieses Problem tritt auch bei der Verwendung von quarternären Ammoniumverbindungen auf. In US 5,139,571 sind beispielsweise Suspensionen beschrieben, in denen zur Einstellung des pH-Werts entsprechende organische Basen eingesetzt werden. In diesem Fall war es das Ziel, eine Diffusion der kleinen Natrium- oder Kaliumionen aus der Suspension in die Waferoberflächen und damit Oberflächendefekte zu vermeiden.

Obwohl an sich geeignete Formulierungen seit geraumer Zeit sowohl zum Planarisieren von Wafern als auch zum Polieren von Metallbeschichtungen, Filmen und leitenden Kontakten eingesetzt werden, sind die mit den bislang verwendeten CMP-Slurries erzielbaren Ergebnisse häufig unzufriedenstellend, da sich während des Polierens durch Lösungsvorgänge und abgetragene kleine Feststoffpartikel von den polierten Flächen die Eigenschaften der CMP-Suspensionen ändern. Ein besonderes Problem ergibt sich bei einer Änderung des pH-Werts während des Poliervorgangs, zumal dieses mit einer Veränderung der Abtragrate verbunden ist.

Es besteht daher seit längerem ein erheblicher Bedarf an verbesserten, preiswerten und einfach herstellbaren Suspensionen für das chemisch-mechanische Polieren, wodurch sowohl Oberflächen von Substratmaterialien als auch von Metallschichten frei von unerwünschten Kontaminationen und Oberflächenfehlern absolut eben erhalten werden können.

Die Lösung der erfindungsgemäßen Aufgabe erfolgt durch Puffersysteme, enthaltend 3 - 25 Gew.-% Kieselsäure in einer 0,5 - 10 molaren wäßrigen Lösung einer starken Base aus der Gruppe TMAH, KOH oder NaOH. Sie sind wirksam im pH-Bereich von 9,5 bis 13.

Die Lösung der erfindungsgemäßen Aufgabe erfolgt auch durch ein Verfahren zur Herstellung des genannten Puffersystems, dadurch gekennzeichnet, daß eine 3 - 25 %-ige wäßrige Kieselsäurelösung oder SiO₂-Suspension bei guter Durchmischung, gegebenenfalls unter Erwärmung, mit solch einer Menge einer wäßrigen Lösung einer starken Base aus der Gruppe TMAH, KOH oder NaOH versetzt wird, daß die im pH-Bereich zwischen 9,5 bis 13 wirksamen Pufferlösung 0,5 bis 10 Mol/L der starken Base enthält.

Gegebenenfalls wird erfindungsgemäß der erhaltenen Pufferlösung das Wasser entzogen, wodurch das Salz des Puffersystems erhalten wird. Dieses kann dadurch erfolgen, daß das Wasser durch Verdampfen im Vakuum entzogen wird oder indem das Salz des Puffers durch anschließendes Abkühlen auskristallisiert wird und die erhaltenen Kristalle abgetrennt werden. Dieses Salz kann dann , gelöst in einer wäßrigen Suspension oder Lösung , die Suspension im stark alkalischen Bereich puffern.

Gegenstand der Erfindung ist somit auch die Verwendung dieses Puffersystems hergestellt nach dem erfindungsgemäßen Verfahren zur Herstellung von alkalischen Suspensionen mit einem pH-Wert zwischen 9,5 bis 13 für chemisch-mechanisches Polieren, insbesondere von Silizium- oder anderen Metalloberflächen.

Erfindungsgemäß können die gepufferten Suspensionen als Schleifmittel Metalloxide in Form von Feststoffpartikeln, ausgewählt aus der Gruppe Siliziumoxid und Aluminiumoxid, sowie Oxidationsmittel und gegebenenfalls weitere Additive enthalten.

Es wurde nun gefunden, daß die Stabilität alkalische Suspensionen für das chemisch-mechanische Polieren durch eine Pufferung im pH-Bereich von 9,5 bis 13 erhöht werden kann. Dieses ist von Bedeutung, da der pH-Wert die lonenschichten an der Waferoberfläche verändert und daher die Abtragungsrate während des Polierens beeinflußt wird. Auch weisen basische Slurries höhere Abtragungsraten auf. Dieses ist darauf zurückzuführen, daß bei der Planarisierung von Si- und anderen Metalloberflächen, wie z. B. Al, Ti, W oder Cu, das Metall durch einen oxidierenden Prozeß gelöst werden muß. Die Abtragung von Silizium in alkalischer Lösung ist eine OH⁻-verbrauchen-de Reaktion, die bei hohen pH-Werten die höchste Reaktionsgeschwindigkeit aufweist. Um nun während des chemisch-mechanischen Polierens die Abtragungsrate möglichst lange unter optimalen Bedingungen ablaufen lassen zu können, sollte der pH-Wert möglichst stabil auf einem hohen Niveau gehalten werden. Eine üblicherweise in diesem pH-Bereich eingesetzte Pufferung durch K₂CO₃ hat sich für die erfindungsgemäße Verwendung der Suspensionen als weniger geeignet erwiesen, da hiermit eine Puffereng bei dem Wert von pH 10,33 erzielt werden kann. Bei der Einstellung von darüber liegenden Werten fällt der pH-Wert schnell wieder auf 10,33 herab.

Versucht man nun den pH-Wert in regelmäßiger Zudosierung einer starken Base zu der Suspension möglichst stabil zu halten, erfährt das Suspensionssystem an der Mischgrenze eine starke Änderung des pH-Werts. Dieses führt im Fall einer SiO₂-Suspension zu einer Reaktion und einer damit verbundenen Veränderung der Komgrößenverteilung der im allgemeinen sehr kleinen Silikatpartikel.

Reaktion und einer damit verbundenen Veränderung der Korngrößenverteilung der im allgemeinen sehr kleinen Silikatpartikel.

Durch Versuche wurde nun gefunden, daß durch Einstellung des pH-Werts mit Hilfe einer geeigneten Pufferlösung dieses Problem vermieden werden kann.

Während Puffersysteme, welche im Bereich von pH-Werten zwischen 11 - 13 wirksam sind und auf der Basis von Phosphat- und Borationen arbeiten, sich als ungeeignet herausgestellt haben, erwiesen sich Kieselsäure-haltige Systeme als ideal. Besonders vorteilhafte Eigenschaften weisen solche Suspensionen auf, wenn die Pufferung durch einen TMAH-haltigen Kieselsäurepuffer (TMAH Tetramethylenammoniumhydroxid) erfolgt und als Poliermittel Silikatpartikel verwendet werden. Durch solche Formulierungen kann insbesondere eine unerwünschte Kontamination durch Fremdionen vermieden werden, da keine weiteren Metallionen in der CMP-Suspension enthalten sind.

Verbesserte Stabilitäten und Poliereigenschaften weisen CMP-Suspensionen auf, welche als Poliermittel etwa 5 bis 15 Gew.-% Silikatpartikel enthalten, wenn zur Einstellung und Pufferung des pH-Werts Pufferlösungen verwendet werden, in denen etwa 3 bis 25 Gew.-% Kieselsäure in einer 0,5 - 10 molaren Lösung einer starken Base aus der Gruppe TMAH, NaOH und KOH enthalten sind. Besonders geeignet sind solche Suspensionen, welche 5 bis 30 Gew.-% Silikatpartikel enthalten. Zur Einstellung des pH-Werts sind ganz besonders Pufferlösungen geeignet, die etwa 5 bis 12 Gew.-% Kieselsäure in einer 5,0 bis 7,5 molaren TMAH-Lösung enthalten.

Neben den Silikatpartikeln als Poliermittel können die erfindungsgemäßen Suspensionen Oxidationsmittel zur Oxidation von Metallschichten zu den korrespondierenden Metalloxiden enthalten, wie beispielsweise Wolfram zu Wolframoxid. Das gebildete Oxid wird dann mechanisch durch das Polieren abgetragen. Einsetzbar sind hierzu die verschiedensten Chemikalien wie entsprechende oxidierende Metallsalze, oxidierende Metallkomplexe, Eisensalze, wie Nitrate, Sulfate, Kaliumferrocyanid und ähnliche Salze, geeignete, Peroxide, Chlorate, Perchlorate, Permanganate, Persulfate und deren Mischungen. Vorzugsweise werden solche Oxidationsmittel verwendet, welche in dem speziellen Anwendungsfall am besten mit den zu behandelnden Oberflächen verträglich sind. Bevorzugt dient daher, soweit es anwendbar und geeignet ist, Wasserstoffperoxid als Oxidationsmittel. Die Konzentration des Oxidationsmittels wird üblicherweise so gewählt, daß eine schnelle Oxidation gewährleistet ist, gleichzeitig aber auch die mechanische Entfernung der Oxide gesichert ist, d. h. daß die Oxidation mit dem mechanischen Polieren sich im Gleichgewicht befinden. Üblicherweise liegt die Konzentration des Oxidationsmittels zwischen 0,5 und 15 Gew.-% bezogen auf die Gesamtsuspension, vorzugsweise zwischen 1 und 7 Gew.-%.

Zur Stabilisierung und zur Verbesserung des Polierergebnisses können die erfindungsgemäßen CMP-Suspensionen außerdem weitere Zusätze enthalten, wie Mittel zur Verhinderung der Sedimentation oder Flocculation der Partikel, der Zersetzung des Oxidationsmittels und eine Reihe von Additiven, wie Tenside, Komplexbildner, polymere Stabilisatoren oder oberflächenaktive Dispersionsmittel, wie oben bereits angesprochen, enthalten. Entsprechende geeignete Zusätze wie Aluminiumsalze, Carbonsäuren, Alkohole, EDTA, Citrate, Natriumsalze, Kaliumsalze, Ammoniumsalze, quarternäre Ammoniumsalze, Phosphoniumsalze sind dem Fachmann aus der Literatur allgemein bekannt. Falls notwendig werden diese Additive in Mengen üblicherweise in einer Menge von 0,001 bis 10 Gew.-% eingesetzt. Es versteht sich von selbst, daß jeweils Konzentrationen gewählt werden, welche einerseits das Ergebnis des chemisch-mechanischen Polierens verbessern, andererseits nicht zu irgendwelchen Nachteilen, wie z. B. Schäumen bei der Zugabe von Tensiden, führen.

Zur Herstellung der erfindungsgemäßen gepufferten CMP-Suspensionen werden die partikelförmigen Siliciumoxide, gegebenenfalls verschiedener Korngröße in der gewünschten Menge mit deionisiertem Wasser vermischt, um eine kolloide Dispersion herzustellen. Durch Vermischung unter Einwirkung von hohen Scherkräften, wie sie durch sehr hohe Rührerdrehzahlen oder durch Einwirkung von Ultraschall erzeugt werden können, wird eine homogene Dispersion hergestellt, alle gewünschten Additive hinzugefügt und der pH-Wert der Suspensionen durch Zugabe einer geeigneten Menge eines Kieselsäure/TMAH-Puffers, wie oben beschrieben, auf den gewünschten Wert zwischen pH 9,5 und 13 eingestellt.

In der vorhergehenden Beschreibung und in den nachfolgenden Beispielen sind Prozentangaben so zu verstehen, daß %-Angaben der hinzugefügten Komponenten der erfindungsgemäßen Formulierungen zu 100 % addieren.

Die im folgenden gegebenen Beispiele dienen zur Verdeutlichung der vorliegenden Erfindung. Aufgrund der allgemeinen Gültigkeit der erfindungsgemäßen Lehre sind sie jedoch nicht geeignet, die Erfindung auf den Gegenstand dieser Beispiele zu beschränken.

### Beispiele

### Beispiel 1

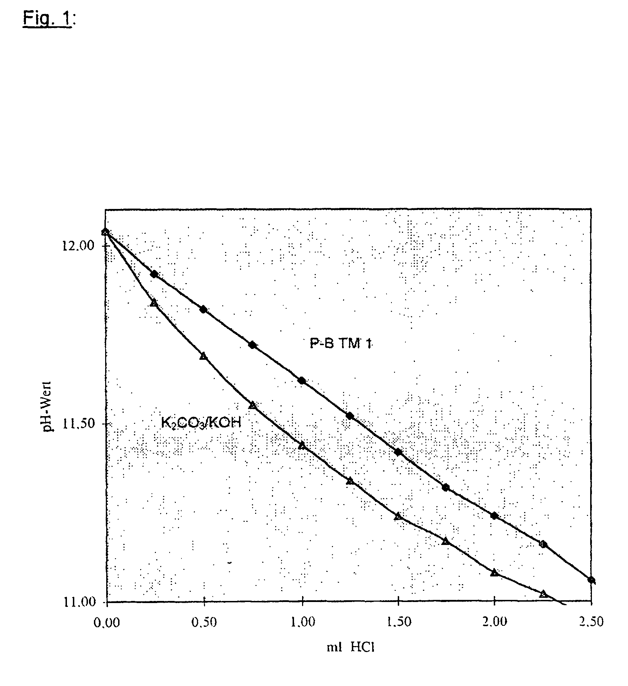

a) Es wird eine 10 %-ige Siliciumoxidsuspension hergestellt. 50 g dieser Suspension werden unter intensivem Rühren mit 5 ml einer 20 %-igen K₂CO₃-Lösung und 1,1 ml einer 10 %-igen KOH-Lösung versetzt. Auf diese Weise wird ein pH-Wert von 12,0 eingestellt.
   Die so erhaltene Suspension wird mit 1 normaler Salzsäure titriert.
b) Es wird eine 10 %-ige Siliciumoxidsuspension hergestellt. 50 g dieser Suspension werden unter intensivem Rühren mit 15 ml eines Puffers TM1 (5,5 Gew.-% Kieselsäure, 8 Gew.-% TMAH) versetzt. Auf diese Weise wird ein pH-Wert von 12,0 eingestellt.
   Die so erhaltene Suspension wird ebenfalls zum Vergleich mit 1 normaler Salzsäure titriert.
   Die Ergebnisse dieser Titrationen sind aus Fig. 1 zu entnehmen. Die darin gezeigten Titrationskurven verdeutlichen das unterschiedliche Verhalten der Suspensionen a) und b) gegenüber dem Einfluß von Salzsäure, d. h. bei Pufferung einer 10 %-igen Siliciumoxid-Suspension bei pH 12 mit einem Puffer TM1 (5,5 Gew.-% Kieselsäure, 8 Gew.-% TMAH) im Vergleich zu einer Pufferung mit einem K₂CO₃/KOH-Puffer

### Beispiel 2

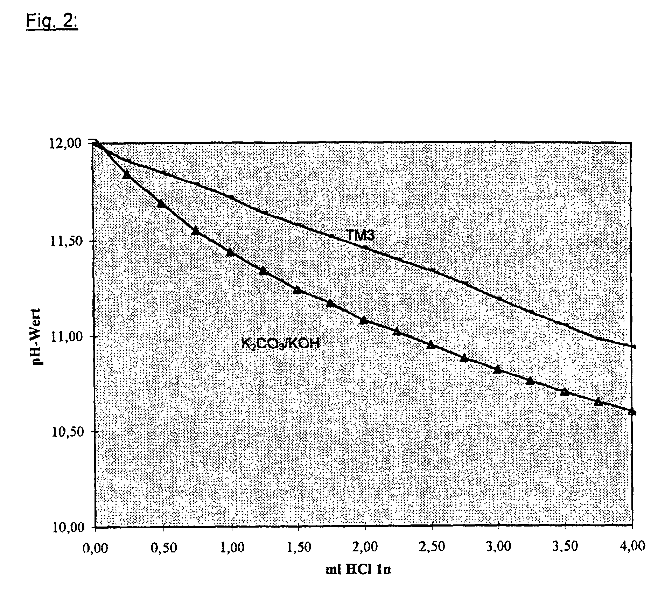

a) Es wird eine 10 %-ige Siliciumoxidsuspension hergestellt. 50 g dieser Suspension werden unter intensivem Rühren mit 5 ml einer 20 %-igen K₂CO₃-Lösung und 1,1 ml einer 10 %-igen KOH-Lösung versetzt. Auf diese Weise wird ein pH-Wert von 12,0 eingestellt.
   Die so erhaltene Suspension wird mit 1 normaler Satzsäure titriert.
b) Es wird eine 10 %-ige Siliciumoxidsuspension hergestellt. 50 g dieser Suspension werden unter intensivem Rühren mit 4 ml eines Puffers TM3 (10 Gew.-% Kieselsäure, 14 Gew.-% TMAH) versetzt. Auf diese Weise wird ein pH-Wert von 12,0 eingestellt.
   Die so erhaltene Suspension wird ebenfalls zum Vergleich mit 1 normaler Salzsäure titriert.
   Die Ergebnisse dieser Titrationen sind aus Fig.2 zu entnehmen. Die darin gezeigten Titrationskurven verdeutlichen das unterschiedliche Verhalten der Suspensionen a) und b) gegenüber dem Einfluß von Salzsäure, d. h. bei Pufferung einer 10 %-igen Siliciumoxid-Suspension bei pH 12 mit einem Puffer TM3 (10 Gew.-% Kieselsäure, 14 Gew.-% TMAH) im Vergleich zu einer Pufferung mit einem K₂CO₃/KOH-Puffer

## Patentansprüche

1. Puffersystem, enthaltend 3 - 25 Gew.-% Kieselsäure in einer 0,5 - 10 molaren wäßrigen Lösung einer starken Base aus der Gruppe TMAH (Tetramethylammoniumhydroxid), KOH oder NaOH.

2. Puffersystem gemäß Anspruch 1, **dadurch gekennzeichnet, daß** es ein Salz des Puffersystems enthält.

3. Verfahren zur Herstellung eines Puffersystems gemäß Anspruch 1 oder gemäß der Ansprüche 1 und 2, **dadurch gekennzeichnet, daß** eine 3 - 25 %-ige wäßrige Kieselsäurelösung bei guter Durchmischung, gegebenenfalls unter Erwärmung, mit solch einer Menge einer wäßrigen Lösung einer starken Base aus der Gruppe TMAH (Tetramethylammoniumhydroxid), KOH oder NaOH versetzt wird, daß die im pH-Bereich zwischen 9,5 bis 13 wirksame Pufferlösung 0,5 bis 10 Mol/L der starken Base enthält.

4. Verfahren gemäß Anspruch 3, **dadurch gekennzeichnet, daß** der erhaltenen Pufferlösung das Wasser entzogen wird, wodurch das Salz des Puffersystems erhalten wird.

5. Verfahren gemäß der Ansprüche 3 - 4, **dadurch gekennzeichnet, daß** das Wasser durch Verdampfen im Vakuum entzogen wird.

6. Verfahren gemäß Anspruch 3, **dadurch gekennzeichnet, daß** das Salz des Puffers durch anschließendes Abkühlen auskristallisiert wird und die erhaltenen Kristalle abgetrennt werden.

7. Verwendung eines Puffersystems gemäß Anspruch 1 oder gemäß der Ansprüche 1 und 2 zur Herstellung von alkalischen Suspensionen für chemisch-mechanisches Polieren mit einem pH-Wert zwischen 9,5 bis 13.

8. Verwendung eines Puffersystems gemäß Anspruch 1 oder gemäß der Ansprüche 1 und 2 zur Herstellung von alkalischen Suspensionen , welche durch Pufferung einen pH-Wert zwischen 9,5 und 13 aufweisen, für chemisch-mechanisches Polieren von Silizium- oder anderen Metalloberflächen.

9. Verwendung eines Puffersystems gemäß Anspruch 1 oder gemäß der Ansprüche 1 und 2 zur Herstellung von alkalischen Suspensionen für chemisch-mechanisches Polieren, welche durch Pufferung einen pH-Wert zwischen 9,5 und 13 aufweisen, als Schleifmittel Metalloxide in Form von Feststoffpartikeln, ausgewählt aus der Gruppe Siliziumoxid und Aluminiumoxid, sowie gegebenenfalls Oxidationsmittel und weitere Additive enthalten.

## Claims

1. Buffer system comprising 3 - 25% by weight of silica in a 0.5 - 10 molar aqueous solution of a strong base selected from the group consisting of TMAH (tetramethylammonium hydroxide), KOH or NaOH.

2. Buffer system according to Claim 1, **characterized in that** it comprises a salt of the buffer system.

3. Process for preparing a buffer system according to Claim 1 or according to Claims 1 and 2, **characterized in that** a 3 - 25% aqueous silica solution is treated while mixing well, if desired with warming, with such an amount of an aqueous solution of a strong base selected from the group consisting of TMAH (tetramethylammonium hydroxide),KOH or NaOH that the buffer solution effective in the pH range from 9.5 to 13 comprises from 0.5 to 10 mol/l of the strong base.

4. Process according to Claim 3, **characterized in that** the water is removed from the buffer solution obtained, giving the salt of the buffer system.

5. Process according to Claims 3-4, **characterized in that** the water is removed by evaporation under reduced pressure.

6. Process according to Claim 3, **characterized in that** the salt of the buffer is crystallized out by subsequent cooling and the resulting crystals are separated off.

7. Use of a buffer system according to Claim 1 or according to Claims 1 and 2 for preparing alkaline suspensions for chemomechanical polishing having a pH of from 9.5 to 13.

8. Use of a buffer system according to Claim 1 or according to Claims 1 and 2 for preparing alkaline suspensions buffered to a pH of from 9.5 to 13 for chemomechanical polishing of silicon or other metal surfaces.

9. Use of a buffer system according to Claim 1 or according to Claims 1 and 2 for preparing alkaline suspensions for chemomechanical polishing which are buffered to a pH of from 9.5 to 13 and comprise, as abrasives, metal oxides in the form of solid particles selected from the group consisting of silicon oxide and aluminium oxide, and, if desired, oxidizing agents and further additives.

## Revendications

1. Système tampon contenant 3-25 % en poids de silice dans une solution aqueuse 0,5-10 molaire d'une base forte choisie dans l'ensemble comprenant le TMAH (hydroxyde de tétraméthylammonium), le KOH ou le NaOH.

2. Système tampon selon la revendication 1, **caractérisé en ce qu'**il contient un sel du système tampon.

3. Procédé de préparation d'un système tampon selon la revendication 1 ou selon les revendications 1 et 2, **caractérisé en ce qu'**on ajoute à une solution aqueuse de silice à 3-25 %, tout en procédant à un mélange intime et éventuellement en chauffant, une quantité d'une solution aqueuse d'une base forte choisie dans l'ensemble comprenant le TMAH (hydroxyde de tétraméthylammonium), le KOH ou le NaOH, telle que la solution tampon, active à un pH compris dans la plage de 9,5 à 13, contienne de 0,5 à 10 mol/l de la base forte.

4. Procédé selon la revendication 3, **caractérisé en ce qu'**on extrait l'eau de la solution tampon obtenue, ce qui permet d'obtenir le sel du système tampon.

5. Procédé selon les revendications 3-4, **caractérisé en ce que** l'eau est extraite par évaporation sous vide.

6. Procédé selon la revendication 3, **caractérisé en ce que** le sel du tampon est séparé par cristallisation sous l'effet d'un refroidissement effectué ensuite, les cristaux obtenus étant séparés.

7. Utilisation d'un système tampon selon la revendication 1 ou selon les revendications 1 et 2 pour préparer des suspensions alcalines pour le polissage chimique ou mécanique, à un pH de 9,5 à 13.

8. Utilisation d'un système tampon selon la revendication 1 ou selon les revendications 1 et 2 pour préparer des suspensions alcalines qui par tamponnage présentent un pH de 9,5 à 13, pour le polissage chimico-mécanique de surfaces de silicium ou d'autres surfaces métalliques.

9. Utilisation d'un système tampon selon la revendication 1 ou selon les revendications 1 et 2 pour préparer des suspensions alcalines pour le polissage chimico-mécanique, qui présentent par tamponnage un pH compris entre 9,5 et 13, et qui en tant que produit abrasif contiennent des oxydes métalliques sous forme de particules solides, choisis dans l'ensemble comprenant l'oxyde de silicium et l'oxyde d'aluminium, et éventuellement des oxydants et d'autres additifs.
